# EUROPEAN PATENT APPLICATION

(11) **EP 4 827 268 A1**
(43) Date of publication of application: **21.10.2026**
(21) Application number: 25171252.7
(22) Date of filing: 17.04.2025
(51) Int. Cl.: H10D 30/01, H10D 30/47, H10D 62/17, H10D 62/854, H10D 62/85

(54) **GROUP III NITRIDE SEMICONDUCTOR DEVICE**

(71) Applicant: Infineon Technologies Austria AG, 9500 Villach (AT)
(72) Inventor: CUBAROVS, Mihails, 9500 Villach (AT); KNUUTTILA, Lauri Olavi, 9500 Villach (AT)
(74) Representative: Infineon Patent Department

(57) **Abstract**

In an embodiment, a Group III nitride semiconductor device is provided that comprises a substrate having a first major surface that is capable of supporting the epitaxial growth of at least one Group III nitride layer, a Group III nitride superlattice arranged on the first major surface of the substrate, a Group III nitride buffer structure arranged on the Group III nitride superlattice, a Group III nitride device layer arranged on the Group III nitride buffer structure. The Group III nitride device layer comprises a power device for switching a load. The Group III nitride superlattice comprises alternate first and second Group III nitride layers which comprise differing bandgaps. The first Group III nitride layer of the superlattice is n-type and the second Group III nitride layer of the superlattice is p-type.

## Description

### BACKGROUND

Group III-nitride semiconductor devices, such as gallium nitride (GaN) devices, are emerging as attractive candidates to carry large currents, support high voltages and to provide very low on-resistance and fast switching times. Group III nitride semiconductor devices may be formed in an epitaxial Group III nitride body that is formed on a base substrate formed of a non-Group III nitride material, such as Si, sapphire or SiC. The Group III nitride body may include a buffer structure arranged on the base substrate and a device layer arranged on the buffer structure.

For example, a device layer for a HEMT (High Electron Mobility Transistor) may comprise a GaN channel layer and a AlGaN barrier layer arranged on the GaN channel layer. A heterojunction is formed at the interface between the AlGaN barrier layer and the GaN channel layer, which is capable of support a two-dimensional charge carrier gas, e.g. a two-dimensional electron gas. The two-dimensional charge carrier gas provides the channel of the transistor device.

The buffer structure is used to compensate for the lattice mismatch between the base substrate ad the Group III nitride body, which Is epitaxially grown on the base substrate, and may also reduce cracking. By compensating for the lattice mismatch, the epitaxially grown Group III nitride layers of the Group III nitride body have reduced crystallographic defects, e.g. a reduced number of dislocations, and the quality if the epitaxy is increased. This leads to an improvement in the performance of the device formed in the device layer.

US 2018/047813 A discloses a substrate structure including a support substrate, a buffer structure arranged on the support substrate. The buffer structure includes an intentionally doped superlattice laminate, an unintentionally doped first Group III nitride layer arranged on the buffer structure, a second Group III nitride layer arranged on the first Group III nitride layer forming a heterojunction therebetween, and a blocking layer arranged between the heterojunction and the buffer structure. The blocking layer is configured to block charges from entering the buffer structure.

Further improvements to buffer structures for Group III nitride semiconductor devices are desirable in order to improve device performance and/or simplify manufacturing of the Group III nitride semiconductor devices.

### SUMMARY

In an embodiment, a Group III nitride semiconductor device is provided that comprises a substrate having a first major surface that is capable of supporting the epitaxial growth of at least one Group III nitride layer, a Group III nitride superlattice arranged on the first major surface of the substrate, a Group III nitride buffer structure arranged on the Group III nitride superlattice, a Group III nitride device layer arranged on the Group III nitride buffer structure. The Group III nitride device layer comprises a power device for switching a load. The Group III nitride superlattice comprises alternate first and second Group III nitride layers which comprise differing bandgaps. The first Group III nitride layer of the superlattice is n-type and the second Group III nitride layer of the superlattice is p-type.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Fig. 1 illustrates a schematic cross-sectional view of a Group III nitride semiconductor device according to an embodiment.
Fig. 2 illustrates a schematic cross-sectional view of a Group III nitride semiconductor device according to an embodiment.
Fig. 3 illustrates a schematic cross-sectional view of a Group III nitride semiconductor device and illustrates an exemplary device layer according to an embodiment.
Fig. 4 illustrates a schematic cross-sectional view of a Group III nitride semiconductor device and illustrates an exemplary device layer according to an embodiment.
Fig. 5 illustrates a schematic cross-sectional view of a Group III nitride semiconductor device and illustrates an exemplary device layer according to an embodiment.
Fig. 6 illustrates a schematic cross-sectional view of a Group III nitride semiconductor device and illustrates an exemplary device layer according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. The terms "aluminum gallium nitride" and "AlGaN" are used herein to denote an alloy described by the formula AlₓGa₍₁₋ₓ₎N, where 0 < x < 1.

The present disclosure proposes a combination of modulation doping and a superlattice in a buffer layer for Group III nitride devices, such as a GaN-based device on a Si substrate, e.g. a GaN-based HEMT (High Electron Mobility Transistor) on a Si substrate, for the reduction of vertical leakage. For example, p-type/n-type modulation doping is introduced into a AlGaN/AlN superlattice and/or into a C-(Al)GaN layer of the buffer structure to add additional layers with bandgap engineering.

This bandgap engineered layer structure has band gap offsets between the alternating p-type and n-type layers and creates extra multiple barriers for the charge carriers to pass through. Alternating p- und n-doping in the superlattice stack may further enhance/increase the potential energy barriers for the charge carriers by further offsetting the AlGaN and AIN energy bands of the supper lattice. This bandgap engineering increases vertical resistance of the device, reducing vertical leakage at same vertical voltage and thus improves the vertical lifetime of the device in load conditions.

The use of p-type/n-type modulation doping may also enable a reduction in the thickness of the buffer structure which may enable a reduction of the epi processing time. This results in a reduction in CO₂ emissions as less power is consumed by the epi tool. Epi thickness reduction may also reduce material consumption thus also reducing CO₂ emissions through the supply chain.

The proposed structures allow a reduction of the epi thickness leading to reduced stress in the wafers and a reduction of the wafer breakage risk as well as a reduction in epi cost. Alternatively, the thickness may be maintained while improving epi vertical lifetime.

In some embodiments, a simple carbon doped superlattice is modified so as to replace the continuous carbon doping with p-doped/n-doped layers. Examples of p-type dopants are Fe, C, Mg and examples of n-type dopants are S, Ge. A further buffer layer, which may be continuously p-doped may be arranged on the modified superlattice. In some embodiments, a superlattice with continuous doping is combined with a modified C-(Al)GaN layer on the superlattice that comprises alternating p-doped/n-doped sublayers. In some embodiments, both the superlattice and the C-(Al)GaN layer on the superlattice comprise alternating p-doped/n-doped sublayers.

Introduction of the alternating p-type/n-type doping in the C-(Al)GaN layer in addition to AlGaN/AlN superlattice creates two bandgap engineered layer structures with band gap offsets between p-type and n-type layers, thus creating extra multiple barriers for the charge carriers to pass through. This band engineering increases vertical resistance of the device reducing vertical leakage at same vertical voltage and thus improvs vertical lifetime in load conditions. A combination of the two approaches may further reduce vertical leakage.

In some embodiments, only parts of the superlattice and/or the (Al)GaN comprise p/n alternately doped superlattice structure and/or comprise p/n alternately doped regions in the (Al)GaN layer.

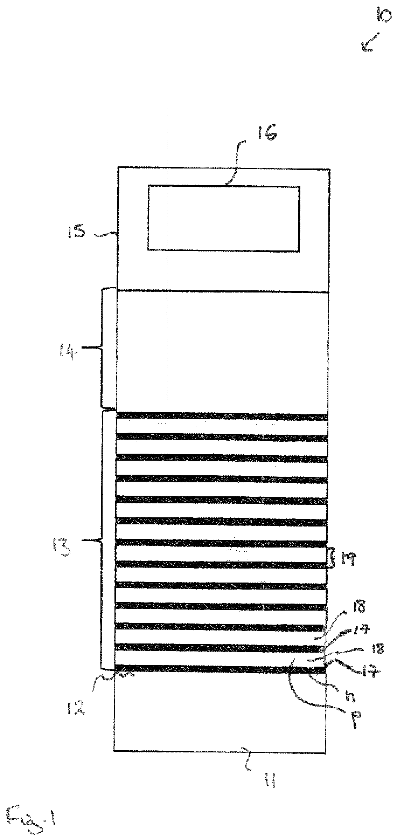

Figure 1 illustrates a schematic cross-sectional view of a Group III nitride semiconductor device 10 according to an embodiment. The Group III nitride device 10 comprises a substrate 11 having a first major surface 12 which is capable supporting the epitaxial growth of at least one Group III nitride layer. A Group III nitride superlattice 13 is arranged on the first major surface 12 of the substrate 11, a Group III nitride-based buffer structure 14 is arranged on the Group III nitride superlattice 13 and a Group III nitride device layer 15 is arranged on the Group III nitride buffer structure 14. The Group III nitride device layer 15 comprises one or more power devices 16 which are suitable for switching a load. The power device 16 may be a transistor device, such as a HEMT (High Electron Mobility Transistor), a diode or a bidirectional switch, for example.

In an embodiment, the Group III nitride-based buffer structure 14 is arranged directly on the Group III nitride superlattice 13 and the Group III nitride device layer 15 is arranged directly on the Group III nitride buffer structure 14. The Group III nitride device layer 15 may comprise two or more sublayers and have a multilayer structure.

The Group III nitride superlattice 13 comprises a plurality of first Group III nitride layers 17 and a plurality of second Group III nitride layers 17 which are alternately stacked on the first major surface 12, to form a first, second first, second arrangement in a stack. The stack has a stacking direction that extends perpendicularly to the first major surface 12 of the substrate 11.

The first and second Group III nitride layers 17, 18 comprise differing bandgaps and different compositions of Group III nitrides. For example, the first Group III nitride 17 layer may be formed of aluminium nitride (AlN). and the second Group III nitride layer 18 may be formed of AlGaN (AlₓGa₍₁₋ₓ₎N, where 0 < x < 1). Furthermore, the first and second Group III nitride layers 17, 18 also comprise dopants of opposing conductivities. The first Group III nitride layer 17 comprises n-type dopants and n-type conductivity and the second Group III nitride layer 18 comprises p-type dopants and p-type conductivity. Thus, a stack of pn junctions is formed by the superlattice 13 on the substrate 11.

The n-type first Group III nitride layer 17 may comprise one or more of the group consisting of Si and Ge dopants and the p-type second Group III nitride layer may comprise one or more of the group consisting of C, Mg and Fe dopants. In one embodiment, the first Group III nitride layer 17 comprises Si dopants and the second Group III nitride layer 18 comprises C dopants. Secondary Ion Mass Spectrometry (SIMS) may be used to determine the presence and level of the n-type e.g. (Si, Ge) and p-type (e.g. C, Fe, Mg) dopants.

The Group III nitride superlattice 13 therefore comprises a plurality of pairs 19, each pair comprising one of the n-type first Group III nitride layers 17 and one of the second p-type Group III nitride layers 18. A heterojunction, since the first and second Group III nitride layers 17, 18 comprise differing bandgaps, and a pn junction is formed between the n-type first Group III nitride layer 17 and the p type Group III nitride layer 18 of each pair 19 as well as between the pairs. Depending on the desired breakdown voltage the superlattice 13 may include between 20 and 100 pairs. In some embodiments, the bottommost layer of the superlattice 13 and the topmost layer is an n-type first Group III nitride layer 17. The n-type first Group III nitride layer 17 may have a smaller thickness than the p type Group III nitride layer 18.

The Group III nitride buffer structure 14, which is arranged between the Group III nitride superlattice 13 and the Group III nitride device layer 1,5 comprises in this embodiment a single layer comprising AlGaN. In an embodiment, the Group III nitride buffer structure 14 is unintentionally doped. Alternatively, this single layer of AlGaN may comprise p type dopants, whereby the doping level throughout the height of the buffer layer 14 is substantially uniform. The single layer of AlGaN is without any n-type layers. The Group III nitride device layer 15 is unintentionally doped.

The substrate 11 may comprise a material other than a Group III nitride and may be called a foreign substrate. The substrate 11 may comprise silicon or sapphire. The Group III nitride layers that make up the superlattice 13, the buffer structure 14 and the device layer 15 are epitaxially grown on the first major surface 12 of the substrate 11. The superlattice 13 and the buffer structure 14 provide a buffer between the substrate 11 and the device layer 15 which serves to compensate for the lattice mismatch between the substrate 11, in particular the first major surface 12 of the substrate 11, and the device layer 15. This reduces the crystallographic defects in the Group III device layer 15, improving the quality of the epitaxy and the performance of the device 16 formed in the Group III nitride device layer 15. The overall height of the buffer in a conventional device may be at least 1 µm. This thickness may be reduced due to the use of the modulated doping of the superlattice 13, i.e. the alternately arranged the n-type first Group III nitride layers 17 and the p-type second Group III nitride layer 18.

The superlattice 13 comprises band gap offsets between adjoining p-type and n-type layers, i.e. between the first and second Group III nitride layers 17, 18, thus creating additional multiple barriers for the charge carriers to pass through. This band engineering increases vertical resistance of the device, thus reducing vertical leakage at same vertical voltage and thus improvs vertical lifetime in load conditions Different compositions for the first and second Group III nitride layers 17, 18 of the superlattice 13 may be used. In one embodiment, the n-type first Group III nitride layer 17 is formed of AIN and the p-type second Group III nitride layer 18 is formed of AlₓGa₍₁₋ₓ₎N, wherein 0 < x < 1. In another embodiment, the n-type first Group III nitride layer 17 is formed of AIN and the p-type second Group III nitride layer 18 is formed of GaN. In yet another embodiment, the n-type first Group III nitride layer 17 is formed of AlₓGa₍₁₋ₓ₎N, wherein 0 < x < 1, and the p-type second Group III nitride layer 18 is formed of Al_{y}Ga_{(1-y)}N, wherein 0 < y < 1 and x ≠ y.

The concertation of the dopants in the first and second Group III nitride layers 17, 18 of the superlattice 13 may be selected to lie within certain ranges. In an embodiment, the n-type first Group III nitride layer 17 comprises n-type dopants in a concentration of 5 e¹⁹ cm⁻³ to 5e¹⁷ cm⁻³ and/or the p-type second Group III nitride layer 18 comprises p-type dopants in a concentration of 5 e²⁰ cm⁻³ to 1 e¹⁸ cm⁻³.

In an embodiment, the n-type first Group III nitride layer 17 comprises Si dopants in a concentration of 5 e¹⁹ cm⁻³ to 5e¹⁷ cm⁻³, preferably around 1e¹⁸ cm⁻³ and the p-type second Group III nitride layer 18 comprises C dopants in a concentration of 5 e²⁰ cm⁻³ to 1 e¹⁸ cm⁻³, preferably around 2e¹⁹ cm⁻³.

The thickness of the first and second Group III nitride layers 17, 18 of the superlattice 13 may be selected to lie within certain ranges. In an embodiment, the n-type first Group III nitride layer 17 has a thickness tₛₙ and the p-type second Group III nitride layer 18 has a thickness tₛₚ, wherein 2 nm ≤ tₛₙ ≤ 8 nm and 10 nm ≤ tₛₚ ≤ 45 nm.

In an embodiment, the first and second Group III nitride layers 17, 18 of the superlattice 13 of the Group III nitride semiconductor device 10 comprise the following combination of features. The n-type first Group III nitride layer 17 is formed of AIN, has a thickness tₛₙ, wherein 2 nm ≤ tₛₙ ≤ 8 nm, and comprises Si dopants in a concentration of 5 e¹⁹ cm⁻³ to 5e¹⁷ cm⁻³ , preferably around 1e¹⁸ cm⁻³ and the p-type second Group III nitride layer 18 is formed of AlₓGa₍₁₋ₓ₎N, wherein 0 < x < 1, has a thickness tₛₚ, wherein 10 nm ≤ tₛₚ ≤ 45 nm, and comprises C dopants in a concentration of 5 e²⁰ cm⁻³ to 1 e¹⁸ cm⁻³ , preferably around 2e¹⁹ cm⁻³.

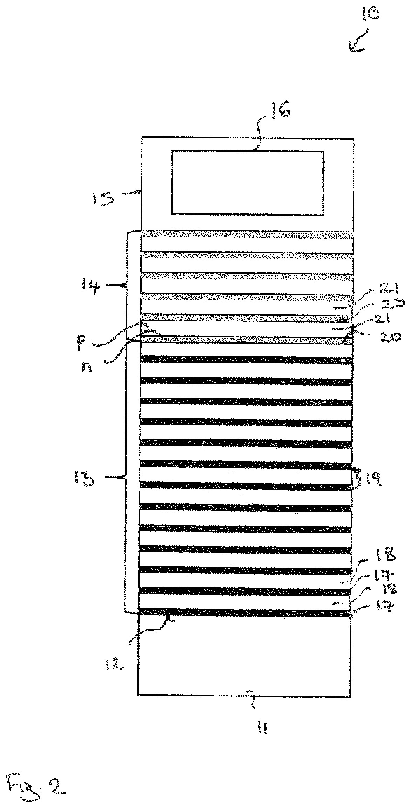

Figure 2 illustrates a schematic cross-sectional view of a Group III nitride semiconductor device 10 which similar to the device described with reference to figure 1 comprises a base substrate 11, a Group III nitride superlattice 13 arranged on a first major surface 12 of the substrate 11, a Group III nitride buffer structure 14 arranged on the Group III nitride superlattice 13 and a Group III nitride device layer 15 arranged on the routine nitride buffer layer 14. One or more power devices 16 which are suitable for switching a load are formed in the Group III nitride device layer 15.

In the embodiment illustrated in figure 2, the Group III nitride buffer layer 14 comprises alternately stacked n-doped layer regions 20 and p-doped layer regions 21. In contrast to the superlattice 13 of the device illustrated in figure 1, the n-doped layer regions 20 and p-doped layer regions 21 of the buffer structure 14 have the same Group III nitride composition, e.g. AlGaN or GaN. In this embodiment, the buffer structure alone provides a stack of pn junctions. In this embodiment, the Group III nitride buffer structure 14 comprises a Group III nitride buffer layer is arranged directly on the superlattice 13.

The n-doped layer regions 20 may comprise one or more of the group consisting of Si and Ge dopants and the p-doped layer regions 21 may comprise one or more of the group consisting of C, Mg and Fe dopants.

The n-type layer regions 20 may comprise n-type dopants in a concentration of 5 e¹⁹ cm⁻³ to 5e¹⁷ cm⁻³ and the p-type layer regions 21 may comprise p-type dopants in a concentration of 5 e²⁰ cm⁻³ to 1 e¹⁸ cm⁻³. In an embodiment, the n-type layer regions 20 comprise Si dopants in a concentration of around 1e¹⁸ cm⁻³ and the p-type layer regions 21 comprise C dopants in a concentration of around 5e¹⁹ cm⁻³.

The individual n-type layer region 20 may have a smaller thickness than the individual p-type layer region 21. For example, the n-type layer regions each have a thickness t_{bn} and the p-type layer regions each have a thickness t_{bp}, wherein 20 nm ≤ t_{bn} ≤ 50 nm and 5 nm ≤ t_{bp} ≤ 20 nm. In an embodiment, 20 nm ≤ t_{bn} ≤ 50 nm and 5 nm ≤ t_{bp} ≤ 20 nm and t_{bn} < t_{bp}.

In the embodiment of figures 2 and in contrast to the embodiment of figure 1, the first and second Group III nitride layers 17, 18 of the superlattice 13 do not have a pn junction between them. The first and second Group III nitride layers 17, 18 of the superlattice 13 are of the same conductivity type, e.g. p-type, or may be unintentionally doped. The first and second Group III nitride layers 17, 18 of the superlattice 13 do, however, have differing Group III nitride compositions and bandgaps, e.g. the first Group III nitride layer 17 is formed of AIN and the second Group III nitride layer 18 is formed of AlₓGa₍₁₋ₓ₎N, wherein 0 < x < 1. Both the first and second Group III nitride layers 17, 18 of the superlattice 13 may be unintentionally doped or both be p-doped, for example include carbon dopants. The Group III nitride device layer 15 is unintentionally doped.

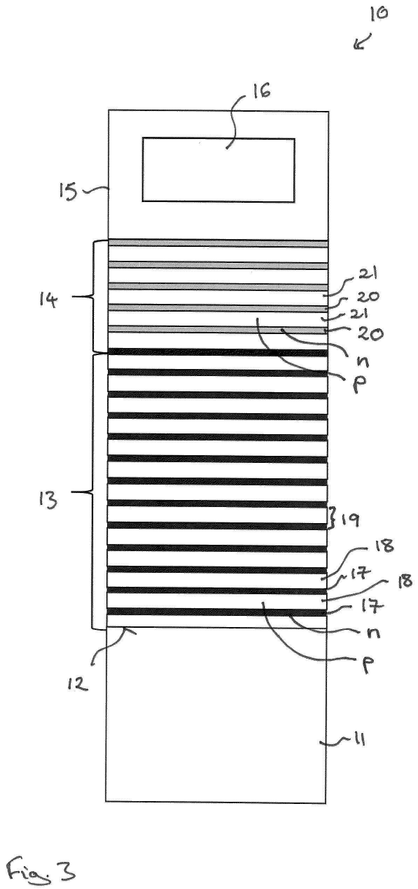

Figure 3 illustrates a schematic cross-sectional view of a semiconductor device 10 according to another embodiment which comprises a combination of the superlattice 13 of figure 1, and the buffer structure 14 of figure 2. The superlattice 13 comprises alternately arranged first and second Group III nitride layers 17, 18 of opposing conductivity types that are stacked such that a pn junction is formed between the first and second Group III nitride layers 17, 18 and that comprise differing Group III nitride compositions such that a heterojunction is formed between the first and second Group III nitride layers 17, 18. The Group III nitride device layer 15 is unintentionally doped.

The buffer structure 14 comprises alternately arranged first and second layer regions 20, 21 which comprise alternative doping types and form a pn junction between the first and second layer regions 20, 21 but form a homojunction between the first and second lateral layer regions 20, 21 since they comprise the same Group III nitride composition. The buffer structure 14 of has alternately arranged n-type layer regions 20 and p-type layer regions 21.

A combination of the alternating p-type/n-type doped layer regions 20, 21 in the buffer layer 14 in addition to the n-type and p-type doping of the layers 17, 18 of the superlattice 13 creates band gap offsets between the p-type and n-type layers, and additional multiple barriers for the charge carriers to pass through. This band engineering structure further increases vertical resistance of the device reducing vertical leakage at same vertical voltage and thus improvs vertical lifetime in load conditions.

This embodiment may be used to increase the number of pn junctions arranged in a stack between the device layer 15 and the substrate 11. The same n-type and p-type dopants may be used in both the superlattice 13 and the buffer structure 14.

The concertation of the dopants in the first and second Group III nitride layers 17, 18 of the superlattice 13 may be selected to lie within certain ranges. In an embodiment, the n-type first Group III nitride layer 17 comprises n-type dopants in a concentration of 5 e¹⁹ cm⁻³ to 5e¹⁷ cm⁻³ and/or the p-type second Group III nitride layer 18 comprises p-type dopants in a concentration of 5 e²⁰ cm⁻³ to 1 e¹⁸ cm⁻³.

In an embodiment, the n-type first Group III nitride layer 17 comprises Si dopants in a concentration of 5 e¹⁹ cm⁻³ to 5e¹⁷ cm⁻³, preferably around 1e¹⁸ cm⁻³ and the p-type second Group III nitride layer 18 comprises C dopants in a concentration of 5 e²⁰ cm⁻³ to 1 e¹⁸ cm⁻³, preferably around 2e¹⁹ cm⁻³.

The thickness of the first and second Group III nitride layers 17, 18 of the superlattice 13 may be selected to lie within certain ranges. In an embodiment, the n-type first Group III nitride layer 17 has a thickness tₛₙ and the p-type second Group III nitride layer 18 has a thickness tₛₚ, wherein 2 nm ≤ tₛₙ ≤ 8 nm and 10 nm ≤ tₛₚ ≤ 45 nm.

In an embodiment, the first and second Group III nitride layers 17, 18 of the superlattice 13 of the Group III nitride semiconductor device 10 comprise the following combination of features. The n-type first Group III nitride layer 17 is formed of AIN, has a thickness tₛₙ, wherein 2 nm ≤ tₛₙ ≤ 8 nm, and comprises Si dopants in a concentration of 5 e¹⁹ cm⁻³ to 5e¹⁷ cm⁻³ , preferably around 1e¹⁸ cm⁻³ and the p-type second Group III nitride layer 18 is formed of AlₓGa₍₁₋ₓ₎N, wherein 0 < x < 1, has a thickness tₛₚ, wherein 10 nm ≤ tₛₚ ≤ 45 nm, and comprises C dopants in a concentration of 5 e²⁰ cm⁻³ to 1 e¹⁸ cm⁻³ , preferably around 2e¹⁹ cm⁻³.

Different compositions for the first and second Group III nitride layers 17, 18 of the superlattice 13 may be used. In one embodiment, the n-type first Group III nitride layer 17 is formed of AIN and the p-type second Group III nitride layer 18 is formed of AlₓGa₍₁₋ₓ₎N, wherein 0 < x < 1. In another embodiment, the n-type first Group III nitride layer 17 is formed of AIN and the p-type second Group III nitride layer 18 is formed of GaN. In yet another embodiment, the n-type first Group III nitride layer 17 is formed of AlₓGa₍₁₋ₓ₎N, wherein 0 < x < 1, and the p-type second Group III nitride layer 18 is formed of Al_{y}Ga_{(1-y)}N, wherein 0 < y < 1 and x ≠ y.

In the buffer structure 14, the n-type layer regions 20 may comprise n-type dopants in a concentration of 5 e¹⁹ cm⁻³ to 5e¹⁷ cm⁻³ and the p-type layer regions 21 may comprise p-type dopants in a concentration of 5 e²⁰ cm⁻³ to 1 e¹⁸ cm⁻³. The individual n-type layer region 20 may have a smaller thickness than the individual p-type layer region 21. For example, the n-type layer regions each have a thickness t_{bn} and the p-type layer regions each have a thickness t_{bp}, wherein 20 nm ≤ t_{bn} ≤ 50 nm and 5 nm ≤ t_{bp} ≤ 20 nm. In an embodiment, 20 nm ≤ t_{bn} ≤ 50 nm and 5 nm ≤ t_{bp} ≤ 20 nm and t_{bn} < t_{bp}.

In an embodiment, the n-type layer regions 20 comprise Si dopants in a concentration of around 1e¹⁸ cm⁻³ and the p-type layer regions 21 comprise C dopants in a concentration of around 5e¹⁹ cm⁻³.

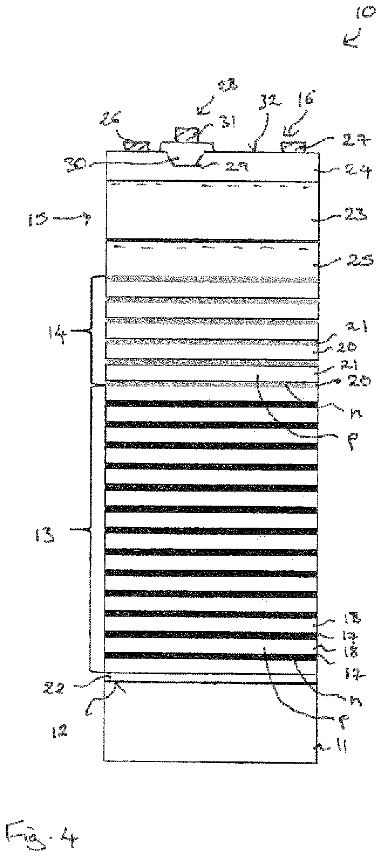

Figure 4 illustrates a semiconductor device 10 according to another embodiment which includes the structure of the superlattice 13 and buffer structure 14 shown in figure 3. The Group III nitride device layer 15 is unintentionally doped. In this embodiment, the semiconductor device 10 further comprises a nucleation layer 22 which is formed on the first major surface 12 of the substrate 11 and which is located between, and in direct contact with, the first major surface 11 and the superlattice 13. For example, if the substrate 11 is formed of silicon, for example monocrystalline silicon or an epitaxial silicon layer, the nucleation layer 22 may be formed of aluminium nitride. The nucleation layer 22 may be used to improve the epitaxy of the lowermost layer of the superlattice 13 and consequently, the epitaxy of the subsequently grown Group III nitride layers 17, 18 of the superlattice 13, buffer structure 14 and device layer 15. A nucleation layer 22 may also be used in the semiconductor devices 10 illustrated in and described with reference to figures 1 to 3.

Figure 4 also illustrates a schematic cross-sectional view of an exemplary structure for the device layer 15. In this embodiment, the device layer 15 comprises a Group III nitride channel layer 23 and a Group III nitride barrier layer 24, the Group III nitride channel layer 23 is arranged on the buffer structure 14. The Group III nitride barrier layer 24 is arranged on the Group III nitride channel layer 23 and forms a heterojunction therebetween that is capable of supporting a two-dimensional charge carrier gas, such as a 2DEG (two-dimensional electron gas) as is schematically depicted in the drawings with a dashed line. The Group III nitride channel layer 23 may be formed of GaN and the Group III nitride barrier layer 24 may be formed of AlGaN (AlₓGa₍₁₋ₓ₎N, wherein 0 < x < 1).

In this embodiment, the Group III nitride device layer 15 further comprises an optional Group III nitride back barrier layer 25 which is arranged between the Group III nitride buffer structure 14 and the Group III nitride channel layer 23. The Group III nitride back barrier layer 25 forms a heterojunction with the Group III nitride channel layer 23 that is capable supporting a two-dimensional charge gas. For example, the Group III nitride back barrier layer may be formed of AlGaN and have a different composition from the AlGaN barrier layer 24, for example the Group III nitride back barrier layer may have a composition of Al_{y}Ga_{(1-y)}N, wherein 0 < y < 1 and x ≠ y. The Group III nitride back barrier layer 25, the Group III nitride channel layer 23 and the Group III nitride barrier layer 24 are unintentionally doped.

In the embodiment illustrated in figure 4, the device formed in the Group III nitride device layer 15 is a transistor device which in this embodiment is a HEMT. The Group III nitride device layer 15 further comprises a first power electrode 26, a second power electrode 27 and a gate 28 which are arranged on an upper surface 32 of the Group III nitride device layer 15, which in this embodiment is formed by the upper surface 32 of the Group III nitride barrier layer 24. The first power electrode 26 may be a source electrode and the second power electrode 27 a drain electrode. The gate 28 is arranged laterally between the source electrode 26 and the drain electrode 27 to form a lateral transistor structure.

The transistor device 16 may be a depletion mode device or an enhancement mode device. The HEMT illustrated in figure 4 is an enhancement mode device and comprises a gate structure 28 comprising a recess 29 formed in the AlGaN barrier layer 24, a p-doped Group III nitride layer 30 that is located in the recess and adjoining portions of the first major surface 12 and a metal gate 31 that is positioned on the p-doped Group III nitride layer 30. The p-doped Group III nitride layer 30 may have a T-shape in cross-section. In some embodiments, a second AlGaN barrier layer may be provided which lines the recess 29. The p-doped Group III nitride layer 30 may comprise p-doped GaN or p-doped AlGaN. Mg dopants may be used to from the p-doped Group III nitride layer 30. The source electrode 26 and the drain electrode 27 may be formed or an ohmic metal, for example Al, or a multilayer structure, for example Ti, Al and a capping metal such as Ti. The gate metal layer 31 may be formed of an ohmic metal, e.g. Al, for forming an ohmic gate or a Schottky metal for forming a Schottky gate. The Schottky metal may be one or more of TiN, Ti, W, WSiₓ, Ta, TaN, Ni, Pd, Pt and Ir.

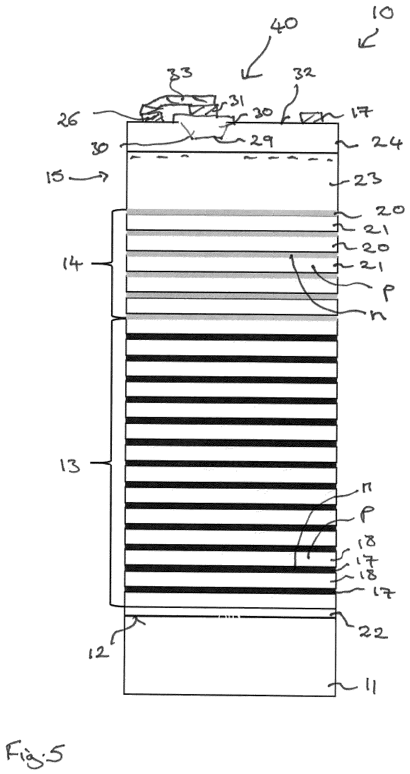

Figure 5 illustrates a schematic cross-sectional view of an exemplary power device 16 according to another embodiment which may be used in the device layer 15 of the embodiments illustrated in figures 1 to 3. The device layer 15 comprises a Group III nitride channel layer 23 and a Group III nitride barrier layer 24 arranged on the Group III nitride channel layer 23 as in the embodiment of figure 4. However, in the embodiment illustrated in figure 5, the back barrier layer is omitted so that the Group III nitride channel layer 23 is in direct contact with the buffer structure 14 in particular the uppermost n-tape layer region 20 of the buffer structure 14.

In this embodiment, the power device 16 is a diode 40 which has a gated diode structure. Similar to the HEMT shown in figure 4, a first power electrode 26, a second power electrode 27 and a gate 28 having a recess 29, a p-doped Group III nitride layer 30 and a gate metal 31 are arranged on the first major surface 32 such that the gate 28 is arranged laterally between the first power contact 26 and the second power contact 27. The gate 28 is electrically connected to the first power contact 26, for example by an electrically conductive layer 33. The first power electrode 26 provides the anode and the second power electrode 28 provides the cathode of the diode.

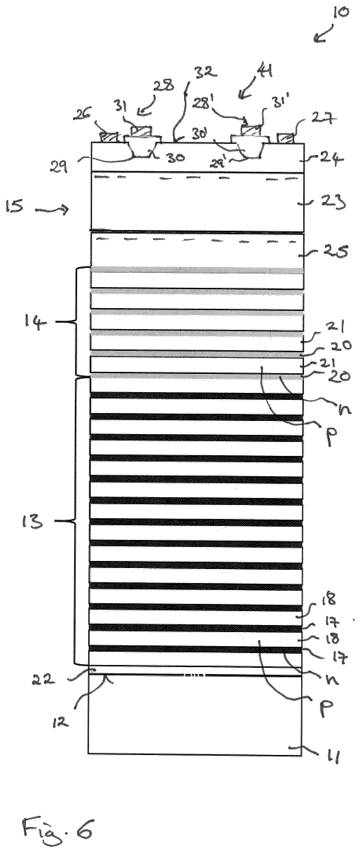

Figure 6 illustrates a schematic cross-sectional view of an exemplary power device 15 according to another embodiment which may be used in the embodiments illustrated in figures 1 to 3. In this embodiment, the device layer 15 comprises a back barrier layer 25 arranged on the buffer structure 14, a Group III nitride channel layer 23 arranged on the back barrier 25 and a Group III nitride barrier layer 24 arranged on the Group III nitride channel layer 23 as in the embodiment of figure 4. However, the back barrier 25 may be omitted.

In this embodiment, the power device is a bidirectional switch 41. The bi-direction switch 41 comprises a first power electrode 26, a second power electrode 27, a first gate 28 and a second gate 28' arranged on the upper surface 32 of the Group III nitride device layer 15. The first and second gates 28, 28' are arranged laterally between the first power electrode 26 and the second power electrode 27 and laterally adjacent one another. Each of the gates 28, 28' comprises a recess 29, a p-doped Group III nitride layer 31 and a gate metal 32 as described with reference to figure 4.

In another non-illustrated embodiment, the bidirectional switch 41 includes a single gate.

To summarise, Group III nitride semiconductor devices are provided which include alternating p-type/n-type doped layer regions 20, 21 in one or both of the buffer layer 14 and the superlattice 13. These alternating doped regions provide band gap offsets between the p-type and n-type layers and additional multiple barriers for the charge carriers to pass through. This band engineering structure increases vertical resistance of the device reducing vertical leakage at same vertical voltage and thus improvs vertical lifetime in load conditions.

The proposed structures may assist in reducing vertical leakage in a Group III nitride-on-Si epi stack which in turn assists in improving the epi vertical lifetime. This is useful for forming high reliability GaN-based devices. A reduction of the epi thickness whilst maintaining same vertical leakage (and vertical blocking voltage) leads to a reduction of epi processing time and reduced cost.

Although the present disclosure is not so limited, the following numbered examples demonstrate one or more aspects of the disclosure.

### Examples

1. A Group III nitride semiconductor device, comprising:
   a substrate having a first major surface that is capable of supporting the epitaxial growth of at least one Group III nitride layer;
   a Group III nitride superlattice arranged on the first major surface of the substrate;
   a Group III nitride buffer structure arranged on the Group III nitride superlattice;
   a Group III nitride device layer arranged on the Group III nitride buffer structure and comprising a power device for switching a load;
   wherein the Group III nitride superlattice comprises alternate first and second Group III nitride layers which comprise differing bandgaps, wherein the first Group III nitride layer is n-type and the second Group III nitride layer is p-type.
2. The Group III nitride semiconductor device according to example 1, wherein the Group III nitride superlattice comprises a plurality of pairs, each pair comprising a n-type Group III nitride layer and a p-type Group III nitride layer, wherein a heterojunction and a pn junction is formed between the n-type Group III nitride layer and the p-type Group III nitride layer of each pair and between pairs of the plurality of pairs.
3. The Group III nitride semiconductor device according to example 1 or example 2, wherein the first and second Group III nitride layers are arranged alternately in a stack.
4. The Group III nitride semiconductor device according to any one of examples to 3, wherein the n-type first Group III nitride layer and the p-type Group III nitride layer have different bandgaps.
5. A Group III nitride semiconductor device according to any one of examples to 3, wherein
   the n-type first Group III nitride layer is formed of AIN and the p-type second Group III nitride layer is formed of AlₓGa₍₁₋ₓ₎N, wherein 0 < x < 1, or
   the n-type first Group III nitride layer is formed of AIN and the p-type second Group III nitride layer is formed of GaN, or
   the n-type first Group III nitride layer is formed of AlₓGa₍₁₋ₓ₎N, wherein 0 < x < 1, and the p-type second Group III nitride layer is formed of Al_{y}Ga_{(1-y)}N, wherein 0 < y < 1 and x ≠ y.
6. A Group III nitride semiconductor device according to any one of examples 1 to 5, wherein the n-type first Group III nitride layer comprises Si or Ge dopants and the p-type second Group III nitride layer comprises C or Mg or Fe dopants.
7. A Group III nitride semiconductor device according to any one of examples 1 to 6, wherein the n-type first Group III nitride layer comprises n-type dopants in a concentration of 5 e¹⁹ cm⁻³ to 5e¹⁷ cm⁻³ and/or the p-type second Group III nitride layer comprises p-type dopants in a concentration of 5 e²⁰ cm⁻³ to 1 e¹⁸ cm⁻³.
8. A Group III nitride semiconductor device according to any one of examples 1 to 7, wherein the n-type first Group III nitride layer comprises Si dopants in a concentration of 5 e¹⁹ cm⁻³ to 5e¹⁷ cm⁻³, preferably around 1e¹⁸ cm⁻³ and the p-type second Group III nitride layer comprises C dopants in a concentration of 5 e²⁰ cm⁻³ to 1 e¹⁸ cm⁻³, preferably around 2e¹⁹ cm⁻³.
9. A Group III nitride semiconductor device according to any one of examples 1 to 8, wherein the n-type first Group III nitride layer has a thickness tₛₙ and the p-type second Group III nitride layer has a thickness tₛₚ, wherein 2 nm ≤ tₛₙ ≤ 8 nm and 10 nm ≤ tₛₚ ≤ 45 nm.
9. A Group III nitride semiconductor device according to any one of examples 1 to 8, wherein
   the n-type first Group III nitride layer is formed of AIN and the p-type second Group III nitride layer is formed of AlₓGa₍₁₋ₓ₎N, wherein 0 < x < 1,
   the n-type first Group III nitride layer has a thickness tₛₙ and the p-type second Group III nitride layer has a thickness tₛₚ, wherein 2 nm ≤ tₛₙ ≤ 8 nm and 10 nm ≤ tₛₚ ≤ 45 nm, and
   the n-type first Group III nitride layer comprises Si dopants in a concentration of 5 e¹⁹ cm⁻³ to 5e¹⁷ cm⁻³ , preferably around 1e¹⁸ cm⁻³ and the p-type second Group III nitride layer comprises C dopants in a concentration of 5 e²⁰ cm⁻³ to 1 e¹⁸ cm⁻³, preferably around 2e¹⁹ cm⁻³.
10. A Group III nitride semiconductor device according to any one of examples 1 to 9, wherein the Group III nitride buffer structure comprises a Group III nitride buffer layer arranged directly on the superlattice, wherein the Group III nitride buffer layer is formed of AlₓGa₍₁₋ₓ₎N, wherein 0 < x < 1 or GaN, and wherein the Group III nitride buffer layer is unintentionally doped.
11. A Group III nitride semiconductor device according to any one of examples 1 to 9, wherein the Group III nitride buffer structure comprises a Group III nitride buffer layer arranged directly on the superlattice, wherein the Group III nitride buffer layer is formed of AlₓGa₍₁₋ₓ₎N, wherein 0 < x < 1 or GaN, and wherein the Group III nitride buffer layer comprises alternately stacked n-doped layer regions and p-doped layer regions.
12. A Group III nitride semiconductor device according to example 11,
   wherein the n-type layer regions comprise n-type dopants in a concentration of 5 e¹⁹ cm⁻³ to 5e¹⁷ cm⁻³ and/or the p-type layer regions comprises p-type dopants in a concentration of 5 e²⁰ cm⁻³ to 1 e¹⁸ cm⁻³, and/or
   wherein the n-type layer regions each have a thickness t_{bn} and the p-type layer regions each have a thickness t_{bp}, wherein 20 nm ≤ t_{bn} ≤ 50 nm and 5 nm ≤ t_{bp} ≤ 20 nm.
13. A Group III nitride semiconductor device according to example 11 or example 12, wherein the n-type layer regions comprise Si dopants in a concentration of around 1e¹⁸ cm⁻³ and the p-type layer regions comprise C dopants in a concentration of around 5e¹⁹ cm⁻³.
14. A Group III nitride semiconductor device according to any one of examples 1 to 13, wherein the power device comprises a transistor device or a bidirectional switch or a diode.
15. A Group III nitride semiconductor device according to example 14, wherein the power device comprises a HEMT (High Electron Mobility Transistor).
16. A Group III nitride semiconductor device according to any one of examples 1 to 15, wherein the Group III nitride device layer further comprises a first power electrode, a second power electrode and a gate arranged on an upper surface of the Group III nitride device layer.
17. A Group III nitride semiconductor device according to any one of examples 1 to 16, wherein the Group III nitride device layer comprises a Group III nitride channel layer arranged on the Group III nitride buffer structure and a Group III nitride barrier layer arranged on the Group III nitride channel layer, forming a heterojunction therebetween capable of supporting a two-dimensional charge carrier gas.
18. A Group III nitride semiconductor device according to any one of examples 1 to 17, wherein the Group III nitride device layer further comprises a Group III nitride back barrier layer that is arranged between the Group III nitride buffer structure and the Group III nitride channel layer and that forms a heterojunction with the Group III nitride channel layer that is capable of supporting a two-dimensional charge carrier gas.
18. A Group III nitride semiconductor device, according to any one of examples 1 to 17, wherein the Group III nitride back barrier layer, the Group III nitride channel layer and the Group III nitride barrier layer are unintentionally doped.
20. A Group III nitride semiconductor device according to any one of examples 1 to 19, wherein the substrate is formed of silicon.
21. A Group III nitride semiconductor device according to example 20, wherein the substrate is formed of monocrystalline silicon or an epitaxial silicon layer.
22. A Group III nitride semiconductor device according to example 20 or example 21, further comprising a AIN nucleation layer formed on the first major surface of the silicon substrate.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A Group III nitride semiconductor device, comprising:
a substrate having a first major surface that is capable of supporting the epitaxial growth of at least one Group III nitride layer;
a Group III nitride superlattice arranged on the first major surface of the substrate;
a Group III nitride buffer structure arranged on the Group III nitride superlattice;
a Group III nitride device layer arranged on the Group III nitride buffer structure and comprising a power device for switching a load;
wherein the Group III nitride superlattice comprises alternate first and second Group III nitride layers which comprise differing bandgaps, wherein the first Group III nitride layer is n-type and the second Group III nitride layer is p-type.

2. A Group III nitride semiconductor device according to claim 1, wherein
the n-type first Group III nitride layer is formed of AIN and the p-type second Group III nitride layer is formed of AlₓGa₍₁₋ₓ₎N, wherein 0 < x < 1, or
the n-type first Group III nitride layer is formed of AIN and the p-type second Group III nitride layer is formed of GaN, or
the n-type first Group III nitride layer is formed of AlₓGa₍₁₋ₓ₎N, wherein 0 < x < 1, and the p-type second Group III nitride layer is formed of Al_{y}Ga_{(1-y)}N, wherein 0 < y < 1 and x ≠ y.

3. A Group III nitride semiconductor device according to claim 1 or claim 2, wherein the n-type first Group III nitride layer comprises Si or Ge dopants and the p-type second Group III nitride layer comprises C or Mg or Fe dopants.

4. A Group III nitride semiconductor device according to any one of claims 1 to 3, wherein the n-type first Group III nitride layer comprises n-type dopants in a concentration of 5 e¹⁹ cm⁻³ to 5e¹⁷ cm⁻³ and/or the p-type second Group III nitride layer comprises p-type dopants in a concentration of 5 e²⁰ cm⁻³ to 1 e¹⁸ cm⁻³.

5. A Group III nitride semiconductor device according to any one of claims 1 to 4, wherein the n-type first Group III nitride layer comprises Si dopants in a concentration of 5 e¹⁹ cm⁻³ to 5e¹⁷ cm⁻³, preferably around 1e¹⁸ cm⁻³ and the p-type second Group III nitride layer comprises C dopants in a concentration of 5 e²⁰ cm⁻³ to 1 e¹⁸ cm⁻³, preferably around 2e¹⁹ cm⁻³.

6. A Group III nitride semiconductor device according to any one of claims 1 to 5, wherein the n-type first Group III nitride layer has a thickness tₛₙ and the p-type second Group III nitride layer has a thickness tₛₚ, wherein 2 nm ≤ tₛₙ ≤ 8 nm and 10 nm ≤ tₛₚ ≤ 45 nm.

7. A Group III nitride semiconductor device according to any one of claims 1 to 6, wherein the Group III nitride buffer structure comprises a Group III nitride buffer layer arranged directly on the superlattice, wherein the Group III nitride buffer layer is formed of AlₓGa₍₁₋ₓ₎N, wherein 0 < x < 1 or GaN, and wherein the Group III nitride buffer layer comprises alternately stacked n-doped layer regions and p-doped layer regions.

8. A Group III nitride semiconductor device according to claim 7,
wherein the n-type layer regions comprise n-type dopants in a concentration of 5 e¹⁹ cm⁻³ to 5e¹⁷ cm⁻³ and/or the p-type layer regions comprises p-type dopants in a concentration of 5 e²⁰ cm⁻³ to 1 e¹⁸ cm⁻³, and/or
wherein the n-type layer regions each have a thickness t_{bn} and the p-type layer regions each have a thickness t_{bp}, wherein 20 nm ≤ t_{bn} ≤ 50 nm and 5 nm 5 t_{bp} ≤ 20 nm.

9. A Group III nitride semiconductor device according to claim 7 or claim 8, wherein the n-type layer regions comprise Si dopants in a concentration of around 1e¹⁸ cm⁻³ and the p-type layer regions comprise C dopants in a concentration of around 5e¹⁹ cm⁻³.

10. A Group III nitride semiconductor device according to any one of claims 1 to 9, wherein the power device comprises a transistor device or a bidirectional switch or a diode.

11. A Group III nitride semiconductor device according to any one of claims 1 to 10, wherein the Group III nitride device layer further comprises a first power electrode, a second power electrode and a gate arranged on an upper surface of the Group III nitride device layer.

12. A Group III nitride semiconductor device according to any one of claims 1 to 11, wherein the Group III nitride device layer comprises a Group III nitride channel layer arranged on the Group III nitride buffer structure and a Group III nitride barrier layer arranged on the Group III nitride channel layer, forming a heterojunction therebetween capable of supporting a two-dimensional charge carrier gas.

13. A Group III nitride semiconductor device according to any one of claims 1 to 12, wherein the Group III nitride device layer further comprises a Group III nitride back barrier layer that is arranged between the Group III nitride buffer structure and the Group III nitride channel layer and that forms a heterojunction with the Group III nitride channel layer that is capable of supporting a two-dimensional charge carrier gas.

14. A Group III nitride semiconductor device according to any one of claims 1 to 13, wherein the substrate is formed of silicon.

15. A Group III nitride semiconductor device according to claim 14, further comprising a AIN nucleation layer formed on the first major surface of the silicon substrate.
